# EUROPÄISCHE PATENTSCHRIFT

(11) **EP 2 191 976 B1**
(45) Veröffentlichungstag und Bekanntmachung des Hinweises auf die Patenterteilung: **15.06.2011**
(21) Anmeldenummer: 09176050.4
(22) Anmeldetag: 16.11.2009
(51) Int. Cl.: B41M 5/26, C23C 14/28, C23C 14/04, C23C 14/06

(54) **Verfahren zum Markieren oder Beschriften eines Werkstücks**
Method for marking or labelling a workpiece
Procédé de marquage ou d'inscription d'une pièce à usiner

(30) Priorität: 01.12.2008 DE 102008059757
(43) Veröffentlichungstag der Anmeldung: 02.06.2010
(73) Patentinhaber: tesa SE, 20253 Hamburg (DE)
(72) Erfinder: Koops, Arne, 23881, Neu-Lankau (DE); Reiter, Sven, 22049, Hamburg (DE)

(56) Entgegenhaltungen:
- WO-A2-2007/032900
- US-A1- 2003 039 765
- US-A1- 2003 071 020

## Beschreibung

Die vorliegende Erfindung betrifft ein Verfahren zum Markieren oder Beschriften eines Werkstücks mit energiereicher Strahlung, insbesondere mit einem Laserstrahl, wobei das Werkstück für die Strahlungswellenlänge transparent ist, und wobei eine Polymermatrix derart in der Nähe des Werkstücks angeordnet wird, dass die Strahlung das Werkstück durchläuft, bevor sie auf die Polymermatrix trifft.

Es ist bekannt, dass die Verwendung einer Laserstrahlung zur Materialbearbeitung eines Werkstücks grundlegend auf einer Absorption der Strahlung und einer Energieumwandlung mit nachfolgenden Prozessen wie Verdampfen, Ionisieren, partikulärem Abtragen und photochemischen Vorgängen basiert. Dabei können diese Prozesse im Werkstück selbst stattfinden, sodass Markierungen oder Beschriftungen beispielsweise in Form einer Gravur erzielt werden, oder ein anderes Material lokal auf dem Werkstück abgeschieden wird, beispielsweise im Rahmen von Laserstrahlverdampfen (engl. pulsed laser deposition, PLD). Varianten des Laserstrahlverdampfens finden insbesondere bei Werkstücken statt, deren Material transparent für die Wellenlänge der verwendeten Laserstrahlung ist.

Beispielsweise wird die absorbierende Polymermatrix in direktem Kontakt mit dem transparenten Werkstück angeordnet, sodass der Laserstrahl das Werkstück durchläuft und beim Auftreffen auf die Grenzfläche zwischen Werkstück und Polymermatrix das Material der Polymermatrix verdampft und sich auf der Oberfläche des Werkstücks als Markierung oder Beschriftung abscheidet.

Das Dokument WO-A-2007/032900 beschreibt ein Verfahren zum Markieren eines mehrschichtigen Materials mit energiereicher Strahlung, insbesondere mit einem Laser, wobei das Material für die Strahlungswellenlänge transparent ist, und wobei das Material eine Polymerschicht enthält. Die Strahlung durchquert das mehrschichtige Material, bevor sie auf die Polymerschicht trifft. Das mehrschichtige Material enthält einen Träger, eine lichtabsorbierende Schicht, und eine thermochromische Schicht.

Die Dokumente US-A1-2003/0071020 und US-A1-2003/0039765 offenbaren ablative Verfahren zur Markierung mit der Verwendung eines Lasers.

Die diesbezüglich bekannten Verfahren haben mehrere Nachteile. Einerseits muss für eine möglichst hohe Auflösung der Markierung oder Beschriftung der Abstand zwischen Werkstück und Polymermatrix möglichst gering sein, damit sich das verdampfte Material auf möglichst kleiner Fläche auf dem Werkstück abscheidet. Hierzu kann beispielsweise eine Polymermatrix in Form einer Transferfolie auf das Werkstück aufgeklebt werden. Falls allerdings eine raue, feuchte, unebene oder verschmutzte Oberfläche des Werkstücks beschriftet werden soll, liegt zumindest lokal häufig kein direkter Kontakt zwischen Polymermatrix und Werkstück vor. Dies kann durch Einschluss von Luftblasen oder anderen flüssigen oder festen Verunreinigungen oder Unebenheiten bedingt sein. Ein Abstand zwischen Polymermatrix und Werkstück bringt dann mehrere Nachteile mit sich. Zum einen gibt es zwei zusätzliche Grenzflächen zwischen Werkstück (optisch dicht) und Luft (optisch dünn) einerseits und Luft (optisch dünn) und Polymermatrix (optisch dicht) andererseits. Dies führt zu unerwünschten Verlusten durch Streuung und Reflexion, wobei ein Teil der Leistung der Laserstrahlung nicht für den gewünschten Verdampfungsprozess zur Verfügung steht, sondern in unerwünschter oder sogar schädigender Weise Bereiche des Werkstücks und/oder der Polymermatrix aufheizt. Zum anderen verteilt sich das abgetragene Material der Polymermatrix auf einen umso größeren Flächenbereich, je größer der Abstand zwischen Polymermatrix und Werkstück ist. Damit wird die Auflösung der Markierung oder Beschriftung schlechter. Im Übrigen ist der Anteil der Menge des auf dem Werkstück abgeschiedenen Materials von der Menge des von der Polymermatrix abgetragenen Materials umso kleiner, je größer der Abstand zwischen Polymermatrix und Werkstück ist. Außerdem kann es zur Erzeugung eines bestimmten Reaktionsprodukts, das als Markierung oder Beschriftung dienen soll, notwendig sein, dass sich in der Polymermatrix bereitgestellte Edukte in einem geschlossenen Reaktionsraum zu dem Produkt reagieren. Durch eine Öffnung zu einem Luftspalt zwischen Polymermatrix und Werkstück kann die Bildung eines solchen Reaktionsraums nicht erreicht werden. Schließlich entsteht beim Materialabtrag an der Polymermatrix so genannter Schmauch, der unerwünschte Nebenprodukte enthält, die ebenfalls aus der Polymermatrix stammen. Möglichst wenig dieses Schmauchs soll sich als Debris in oder um die Markierung oder Beschriftung am Werkstück mischen. Die Schmauchentwicklung ist bei Lufteinschluss zwischen Polymermatrix und Werkstück größer und verursacht unsaubere Ergebnisse.

Außer einem Verfahren mit einer festen Polymermatrix sind Laserverfahren bekannt, die auf der Erhöhung der oberflächennahen Absorption von Laserstrahlung durch eine Flüssigkeit basieren. Dabei wird bewusst ein absorbierendes Medium verwendet, üblicherweise eine organische Flüssigkeit. Das transparente Werkstück steht dabei an der zu bearbeitenden Rückseite in Kontakt mit der Flüssigkeit, die Lasereinstrahlung erfolgt durch die Vorderseite. Durch das Absorbieren der Laserstrahlung in der Flüssigkeit entsteht über den Wärmetransport aus der erhitzten Flüssigkeit ein schneller Temperaturanstieg bis über den Schmelz- und Verdampfungspunkt der Glasmatrix. Dieses als "laser-induced backside wet etching" (LIBWE) bezeichnete Verfahren führt zum Materialabtrag an der Glasoberfläche und wird zur Mikrostrukturierung bzw. Mikrogravierung von Glas verwendet.

Wird eine benetzende Absorberflüssigkeit gewählt, so kann ein aus oben genannten Gründen unerwünschter Lufteinschluss zwischen Flüssigkeit und Werkstück zwar vermieden werden. Nachteilig an einer Flüssigkeit als Absorber ist jedoch, dass damit kein lokalisierter Materialabtrag und kein anschließendes lokalisiertes Abscheiden auf dem Werkstück erzielt werden kann, sondern nur ein durch Wärmeübertragung erzeugter Materialabtrag am Werkstück, also beispielsweise nur eine Gravur.

Aufgabe der vorliegenden Erfindung ist es daher, ein verbessertes. Verfahren zum Markieren oder Beschriften eines Werkstücks mit energiereicher Strahlung, insbesondere mit einem Laserstrahl, bereitzustellen, bei dem die Nachteile der bekannten Verfahren überwunden werden und auch raue, feuchte, unebene oder verschmutzte Oberflächen des Werkstücks mit hoher Qualität und Auflösung markiert oder beschriftet werden können.

Gelöst wird diese Aufgabe durch ein Verfahren gemäß Anspruch 1. Bevorzugte Ausführungsformen sind Gegenstand der abhängigen Unteransprüche.

Gemäß der vorliegenden Erfindung wird ein Verfahren zum Markieren oder Beschriften eines Werkstücks mit energiereicher Strahlung, insbesondere mit einem Laserstrahl, bereitgestellt. Das Werkstück ist dabei für die Strahlungswellenlänge transparent und eine Polymermatrix wird derart in der Nähe des Werkstücks angeordnet, dass die Strahlung das Werkstück durchläuft, bevor sie auf die Polymermatrix trifft. Das Verfahren zeichnet sich dadurch aus, dass zwischen der Polymermatrix und dem Werkstück ein Flüssigkeitsfilm angeordnet wird, der in Kontakt mit der Polymermatrix und dem Werkstück steht.

Als Polymermatrix wird vorliegend jede Matrix basierend auf polymeren Bestandteilen bezeichnet. Neben den polymeren Bestandteilen kann die Matrix auch beliebige nicht polymere Bestandteile enthalten, wobei lediglich der Hauptbestandteil polymerer Art sein sollte. Insbesondere bezeichnet der Begriff "Polymermatrix" auch eine Mischung von Grundpolymeren. In besonders bevorzugter Ausgestaltung handelt es sich bei der Polymermatrix um eine duroplastische Polymermatrix. Es hat sich gezeigt, dass insbesondere Duroplaste besonders geeignet sind, um ein Werkstück zu markieren oder zu beschriften.

Durch die erfindungsgemäße Anordnung des Flüssigkeitsfilms werden mehrere Nachteile des. Standes der Technik. überwunden. Zum einen wird bei einer zu markierenden oder zu beschriftenden rauen, feuchten, unebenen oder verschmutzten Oberfläche des Werkstücks ein Abstand zwischen Werkstück und Polymermatrix durch die Flüssigkeit ausgefüllt. Wenn der vorzugsweise benetzende Flüssigkeitsfilm eine ähnliche Brechzahl wie das Werkstück hat, wird die optisch raue Oberfläche geglättet, sodass der Laserstrahl beim Austritt aus dem Werkstück ohne durch die optisch raue Oberfläche hervorgerufene störende Totalreflexionen und Streuungen und mit einem erheblich verringerten Reflexionsgrad durchlaufen kann. Des Weiteren schränkt der Flüssigkeitsfilm die Ausweitung der Fläche ein, auf der sich das Material der Polymermatrix abscheidet. Durch den hohen Energieeintrag verdampft nämlich lokal der Flüssigkeitsfilm und bildet eine tunnelartige Blase, durch die sich das abgetragene Material seitlich begrenzt auf das Werkstück zu bewegt. Die Auflösung wird also trotz eines Abstands zwischen Werkstück und Polymermatrix nicht wesentlich beeinträchtigt. Außerdem verhindert der Flüssigkeitsfilm die Entstehung von Schmauch bzw. wird der Schmauch im Flüssigkeitsfilm gelöst oder suspendiert. Damit wird die Qualität und Reinheit der Markierung und Beschriftung wesentlich verbessert. Auch gegenüber einem direkten Kontakt zwischen Werkstück und Polymermatrix hat das erfindungsgemäße Verfahren einen Vorteil, nämlich die Funktion des Flüssigkeitsfilms als Wärmeisolationsschicht oder Wärmeableiter, der eine unerwünschte Erwärmung des Werkstücks minimiert. Der Flüssigkeitsfilm ist vorzugsweise möglichst transparent für die Laserstrahlung und nimmt daher selbst kaum Laserstrahlungsenergie auf, sondern nur die Wärme der erhitzten Polymermatrix. Diese wird durch Wärmeleitung und Konvektion unter Bewegung durch die lokale Verdampfung der Flüssigkeit abtransportiert und nicht lokal konzentriert auf das Werkstück übertragen.

Damit an den Grenzflächen zwischen Werkstück und dem Medium möglichst wenig Reflexion stattfindet, ist es vorteilhaft, wenn das flüssige oder viskoelastische Medium eine ähnliche Brechzahl wie das Material des Werkstücks hat. Es hat sich gezeigt, dass mit einem Differenzbetrag der Brechzahlen von weniger als 0,5 ausreichend gute Ergebnisse erzielt werden.

Als Strahlungsquelle wird vorzugsweise ein Laser verwendet, der sich zum Markieren, Beschriften oder Gravieren von Werkstücken eignet. Dies ist beispielsweise ein fasergekoppelter Festkörper-Diodenlaser wie etwa ein FAYb-Faserlaser (Fiber Amplified Ytterbium) mit einer Wellenlänge von 1064 nm und einer mittleren Leistung von 12 bis 15 W. Da also Strahlung im Wellenlängenbereich von 600 nm - 1500 nm verwendet wird, ist es von Vorteil, wenn das flüssige oder viskoelastische Medium in dem Wellenlängenbereich von 600 nm - 1500 nm keine Absorption zeigt oder einen Absorptionsgrad von weniger als 10% hat. Dies gilt ebenso für das Material des Werkstücks, das vorzugsweise ein Glassubstrat ist. Entgegengesetzt zu dem beschriebenen LIBWE-Verfahren, wird hier also eine Flüssigkeit verwendet, die ein geringes oder kein Absorptionsvermögen bei der verwendeten Wellenlänge besitzt.

In einer bevorzugten Ausführungsform des erfindungsgemäßen Verfahrens wird durch die Strahlung ein Materialabtrag an der Polymermatrix hervorgerufen und der Flüssigkeitsfilm nimmt abgetragene Bestandteile der Polymermatrix und/oder daraus entstehende Produkte auf.

Die Polymermatrix kann zum Beispiel einen Titanspender sowie einen Kohlenstoffspender aufweisen. Als Titanspender dient dabei reines Titan oder eine Titanverbindung, die eine Affinität hat, unter Energieeinwirkung kurzzeitig freies Titan als Edukt bereitzustellen. Gegebenenfalls kann die Bereitstellung des freien Titans auch über den Weg eines titanhaltigen Zwischenprodukts erfolgen. Der Kohlenstoffspender stellt insbesondere unter Energieeinstrahlung freien Kohlenstoff bereit. Bei dem Kohlenstoffspender kann es sich um eine Kohlenstoffverbindung und/oder um freien, nicht gebundenen Kohlenstoff handeln. Der Kohlenstoffspender kann dabei durch die Polymermatrix selbst bereitgestellt werden, es kann aber auch eine zusätzliche Kohlenstoffkomponente, beispielsweise in Form von Ruß, vorhanden sein. Zudem kann die Polymermatrix auch weitere Komponenten wie zum Beispiel Polymere, Absorber etc. enthalten. Durch die Strahlung kommt es zum Bereitstellen der Edukte Titan und Kohlenstoff, beispielsweise durch ein Aufbrechen einer Titanverbindung sowie einer Kohlenstoffverbindung, und es bildet sich unter Einwirkung von Strahlung als gewünschtes Produkt Titancarbid. Vorzugsweise wird bei lokaler Temperatur von 1700°C bis 2200°C Titandioxid mit Ruß oder reinstem Graphit zu Titancarbid und Kohlenmonoxid reduziert. Die Strahlung bewirkt dabei die für die Reaktion notwendige Temperatur im Reaktionsraum.

Die Polymermatrix ist derart ausgebildet, dass sie auf die Laserbestrahlung überwiegend mit Pulverisierung reagiert, wodurch die einzelnen Edukte, insbesondere Titan und Kohlenstoff, freigesetzt werden und für die Reaktion zu Titancarbid zur Verfügung stehen.

Des weiteren hat es sich als vorteilhaft herausgestellt, wenn für den Flüssigkeitsfilm eine Flüssigkeit gewählt wird, die in dem Wellenlängenbereich von 600 - 1500 nm keine Absorption zeigt oder einen Absorptionsgrad von weniger als 10% hat und Strahlung im Wellenlängenbereich von 600 - 1500 nm verwendet wird. Es kann für den Flüssigkeitsfilm ein Sol, Gel oder eine viskoelastische Substanz gewählt werden, wobei der Flüssigkeitsfilm eine Schichtdicke von 250 nm - 10 mm aufweisen kann.

Die Flüssigkeit kann auch selbst Bestandteile enthalten, die als Edukte oder Katalysatoren für erwünschte Reaktionen bereitgestellt werden. In dem Flüssigkeitsfilm können sich dafür ggf. Ionen lösen, die als Edukte oder Katalysatoren für eine gewünschte Reaktion zu einem Produkt bereitstehen, wobei sich das Produkt dann unter Einwirkung energiereicher Strahlung auf dem Werkstück abscheiden kann.

Der Flüssigkeitsfilm ändert vorzugsweise unter Einwirkung der Strahlung lokal seinen Aggregatszustand und wird insbesondere gasförmig. Damit wird ein räumlich begrenzter tunnelartiger Raum zum Abscheiden des abgetragenen Materials oder der Produkte daraus auf möglichst kleiner Fläche des Werkstücks geschaffen.

Im Folgenden wird eine bevorzugte Ausführungsform des Verfahrens anhand der beigefügten Figuren genauer erläutert.
Fig. 1 zeigt ein nachteiliges Verfahren, bei dem sich eine Luftschicht zwischen Werkstück und Polymermatrix befindet.
Fig. 2 zeigt ein vorteilhaftes Verfahren, bei dem sich ein Flüssigkeitsfilm zwischen Werkstück und Polymermatrix befindet.

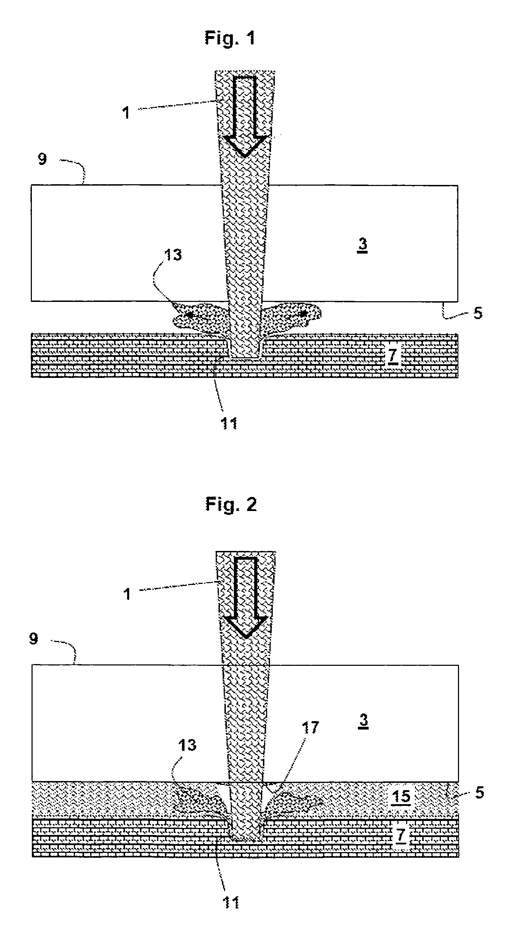

In Fig. 1 ist gezeigt wie ein Laserstrahl 1 auf ein Werkstück 3 in Form eines Glassubstrats gerichtet ist, das auf einer Oberfläche 5 markiert oder beschriftet werden soll. In der Nähe der Oberfläche 5 des Werkstücks 3 ist mit einem Abstand eine Polymermatrix 7 angeordnet. Zwischen Polymermatrix 7 und Werkstück 3 ist also ein Luftspalt. Der Luftspalt kann bewusst angeordnet sein oder unbewusst durch eine Rauigkeit, Unebenheit, Feuchtigkeit oder Schmutz auf der Oberfläche 5 des Werkstücks oder der Polymermatrix 7 bedingt sein. Das Werkstück 3 ist für die Wellenlänge des Laserstrahls 1 transparent, wogegen die Polymermatrix 7 den Laserstrahl 1 hauptsächlich absorbiert. Der Laserstrahl 1 tritt über eine Oberfläche 9 des Werkstücks 3, die der zu markierenden Oberfläche 5 gegenüberliegt, in das Werkstück 3 ein, durchläuft es und trifft auf die Polymermatrix 7, die den Laserstrahl 1 absorbiert und sich aufheizt bis die thermische Energie so groß ist, dass die Polymermatrix 7 pulverisiert.

Durch die Pulverisierung entsteht ein zum Luftspalt hin offener Reaktionsraum 11 innerhalb der Polymermatrix 7, in dem sich im pulverisierten Material Edukte befinden, die für eine gewünschte Reaktion bereitstehen. Die Edukte sind in diesem Beispiel Titandioxid und reiner Kohlenstoff in Form von Ruß, wobei das Titandioxid bei einer durch die Strahlung erzeugten lokalen Temperatur von 1700°C bis 2200°C zu Titancarbid als Produkt zur Abscheidung als Markierung oder Beschriftung reduziert werden soll. Da der Reaktionsraum 11 jedoch zum Luftspalt hin offen ist, wird mit der Pulverisierung eine starke Entwicklung von Schmauch 13 und anderen unerwünschten Nebenprodukten hervorgerufen. Das abgetragene Material entweicht vorzeitig mit dem Schmauch 13 und anderen Nebenprodukten aus dem Reaktionsraum 11 in den Luftspalt, ohne dass es zu einer Reaktion zu Titancarbid und zur Abscheidung auf der Oberfläche 5 des Werkstücks 3 kommt. Die Oberfläche 5 des Werkstücks 3 wird lediglich mit Schmauch und anderen unerwünschten Nebenprodukten verschmutzt.

Figur 2 zeigt eine vorteilhafte Ausführungsform des Verfahrens, bei dem zwischen der Oberfläche 5 des Werkstücks 3 und der Polymermatrix 7 ein Flüssigkeitsfilm 15 angeordnet ist. Dazu wurde die Oberfläche 5 des Werkstücks 3 oder die Polymermatrix 7 mit einer Flüssigkeitsmenge von 0,1 ml über eine Pipette beträufelt und in einem Bereich von 5 cm x 5 cm verteilt. Aufgrund der Oberflächenspannung ist es möglicherweise erforderlich, durch Bewegung der Glasplatte oder durch einen Luftstrahl einen gleichmäßigen Flüssigkeitsfilm zu erzeugen oder durch Zusätze die Flüssigkeit benetzend zu machen. Bei der Flüssigkeit handelt es sich um demineralisiertes Wasser, welches häufig in der chemischen und pharmazeutischen Industrie Verwendung findet. Danach wird die Polymermatrix als Folienmaterial so auf den Flüssigkeitsfilm 15 appliziert, dass ein Flüssigkeitsfilm 15 mit einer Filmdicke von 20 µm bis 100 µm ausbildet. Es ist dazu auch möglich, die Flüssigkeit auf die Polymermatrix 7 aufzutragen und den durch die Oberflächenspannung entstandenen Tropfen durch das Auflegen des Werkstücks 3 in der Größe von 48 x 14 mm eine gleichmäßige Verteilung der Flüssigkeit zu erzeugen. Die Filmdicke kann durch einen Distanzhalter zwischen Polymerfolie 7 und Glas 3 bestimmt werden. Es ist nach Möglichkeit darauf zu achten, dass die Filmschicht homogen und ohne Luftanhaftungen an den Grenzflächen verteilt ist.

Zur Erzeugung der Laserstrahlung wird ein Feststoffkörperlaser (nicht gezeigt) verwendet, der eine Wellenlänge von 1064 nm emittiert. Vorzugweise wird ein fasergekoppelter Diodenlaser verwendet, wie dieser von der Firma Panasonic Electric Works Europe AG in Deutschland unter dem Handelsnamen "SunX LP-V10" angeboten wird. Bei der verwendeten Laserstrahlung handelt es sich also um die Wellenlänge von 1064 nm, für die Glas und Wasser durchlässig ist.

Da das Glas einen kleinen Absorptionskoeffizienten besitzt, durchläuft der Laserstrahl 1 dieses Medium und geht an der Grenzfläche vom Glas 3 zum Wasser 15 über. Auch Wasser besitzt bei der dieser Wellenlänge kein Absorptionsvermögen und lässt den Laserstrahl nahezu verlustfrei auf die Polymermatrix 7 treffen.

Bei der Laserstrahl-Wechselwirkung mit der Polymermatrix 7 reagiert diese wie bereits im Verfahren von Figur 1 mit Pulverisierung. Über die sich ausbildende Schockwelle, bedingt durch zusätzlich gasförmige Expansion werden Schmauch 13 und Nebenprodukte in die Flüssigkeitsschicht 15 katapultiert und darin gelöst bzw. suspendiert. Der in der Polymermatrix 7 entstehende Reaktionsraum 11 ist nach oben hin zunächst durch den Flüssigkeitsfilm 15 begrenzt, sodass sich das pulverisierte Material der Polymermatrix 7 unter Einwirkung des Laserstrahls 1 auf 1700°C bis 2200°C im Reaktionsraum 11 aufheizt und Titancarbid als Produkt aus durch die pulverisierte Polymermatrix 7 bereitgestellten Edukten Titandioxid und Kohlenstoff entstehen kann. Bei diesem Vorgang verdampft lokal auch der Flüssigkeitsfilm 15 und bildet eine tunnelartige Blase, die sich bis zur Oberfläche 5 des Werkstücks 3 ausbreitet. Durch die explosionsartige Schockwelle wird Titancarbid auf die Oberfläche 5 des Werkstücks 3 geschleudert, worauf sich das Titancarbid lokal begrenzt abscheidet. Durch seitliches Verschieben des Laserstrahls 1 oder des Werkstücks 3 samt Polymermatrix 7 und Flüssigkeitsfilm 15 kann dann eine im Wesentlichen zweidimensionale Struktur von Titancarbid auf der Glasoberfläche 5 abgeschieden werden.

Nach diesem Prozess wird die Polymermatrix 7 von der Glasplatte 3 abgelöst und der schmauch- und partikelhaltige Flüssigkeitsfilm 15 entfernt, wobei das abgeschiedene Titancarbid als Markierung oder Beschriftung 17 auf der Glasoberfläche 5 dauerhaft verbleibt.

## Patentansprüche

1. Verfahren zum Markieren oder Beschriften eines Werkstücks (3) mit energiereicher Strahlung, insbesondere mit einem Laserstrahl (1), wobei das Werkstück (3) für die Strahlungswellenlänge transparent ist, und wobei eine Polymermatrix (7) derart in der Nähe des Werkstücks (3) angeordnet wird, dass die Strahlung das Werkstück (3) durchläuft, bevor sie auf die Polymermatrix (7) trifft, **dadurch gekennzeichnet, dass** zwischen der Polymermatrix (7) und dem Werkstück (3) ein Flüssigkeitsfilm (15) angeordnet wird, der in Kontakt mit der Polymermatrix (7) und dem Werkstück (3) steht.

2. Verfahren nach Anspruch 1, wobei durch die Strahlung ein Materialabtrag an der Polymermatrix (7) hervorgerufen wird und der Flüssigkeitsfilm (15) abgetragene Bestandteile der Polymermatrix (7) und/oder daraus entstehende Produkte aufnimmt.

3. Verfahren nach Anspruch 1 oder 2, wobei für den Flüssigkeitsfilm (15) eine Flüssigkeit gewählt wird, die in dem Wellenlängenbereich von 600 - 1500 nm keine Absorption zeigt oder einen Absorptionsgrad von weniger als 10% hat, und Strahlung im Wellenlängenbereich von 600 - 1500 nm verwendet wird.

4. Verfahren nach einem der vorhergehenden Ansprüche, wobei für den Flüssigkeitsfilm (15) ein Sol, Gel oder eine viskoelastische Substanz gewählt wird.

5. Verfahren nach einem der vorhergehenden Ansprüche, wobei der Flüssigkeitsfilm (15) eine Schichtdicke von 250 nm - 10 mm aufweist.

6. Verfahren nach einem der vorhergehenden Ansprüche, wobei sich in dem Flüssigkeitsfilm (15) Ionen lösen, die als Edukte für eine gewünschte Reaktion zu einem Produkt bereitstehen, wobei sich das Produkt unter Einwirkung energiereicher Strahlunq, insbesondere eines Laserstrahls (1), auf dem Werkstück (3) abscheidet.

7. Verfahren nach einem der vorhergehenden Ansprüche, wobei der Flüssigkeitsfilm (15) unter Einwirkung der Strahlung lokal seinen Aggregatszustand ändert, insbesondere gasförmig wird.

## Claims

1. Method of marking or inscribing a workpiece (3) with high-energy radiation, more particularly with a laser beam (1), the workpiece (3) being transparent for the radiation wavelength, and a polymer matrix (7) being disposed in the vicinity of the workpiece (3) in such a way that the radiation passes through the workpiece (3) before it impinges on the polymer matrix (7), **characterized in that** disposed between the polymer matrix (7) and the workpiece (3) is a film (15) of liquid which is in contact with the polymer matrix (7) and with the workpiece (3).

2. Method according to Claim 1, wherein the radiation induces removal of material from the polymer matrix (7), and the film (15) of liquid takes up removed constituents of the polymer matrix (7) and/or products formed therefrom.

3. Method according to Claim 1 or 2, wherein for the film (15) of liquid a liquid is selected which in the wavelength range of 600-1500 nm exhibits no absorption or has a degree of absorption of less than 10%, and radiation in the wavelength range of 600-1500 nm is used.

4. Method according to any of the preceding claims, wherein for the film (15) of liquid a sol, a gel or a viscoelastic substance is selected.

5. Method according to any of the preceding claims, wherein the film (15) of liquid has a thickness of 250 nm-10 mm.

6. Method according to any of the preceding claims, wherein ions dissolve in the film (15) of liquid that are ready as reactants for a desired reaction to form a product, the product depositing on the workpiece (3) from exposure to high-energy radiation, more particularly to a laser beam (1).

7. Method according to any of the preceding claims, wherein, on exposure to the radiation, the film (15) of liquid locally changes its aggregate state, and more particularly becomes gaseous.

## Revendications

1. Procédé pour marquer ou mettre une inscription sur une pièce (3) avec un rayonnement riche en énergie, en particulier avec un rayon laser (1), où la pièce (3) est transparente à la longueur d'onde de rayonnement et où une matrice polymère (7) est disposée à proximité de la pièce (3) de manière telle que le rayonnement traverse la pièce (3) avant qu'il ne rencontre la matrice polymère (7), **caractérisé en ce qu'**un film de liquide (15) qui est en contact avec la matrice polymère (7) et la pièce (3) est disposé entre la matrice polymère (7) et la pièce (3).

2. Procédé selon la revendication 1, où une élimination du matériau est provoquée par le rayonnement sur la matrice polymère (7) et le film de liquide (15) reprend les constituants éliminés de la matrice polymère (7) et/ou les produits formés à partir de ceux-ci.

3. Procédé selon la revendication 1 ou 2, où on choisit, pour le film de liquide (15), un liquide qui ne présente pas d'absorption dans la plage de longueurs d'onde de 600-1500 nm ou qui présente un degré d'absorption inférieur à 10% et on utilise un rayonnement dans la plage de longueurs d'onde de 600-1500 nm.

4. Procédé selon l'une quelconque des revendications précédentes, où on choisit, pour le film de liquide (15), un sol, un gel ou une substance viscoélastique.

5. Procédé selon l'une quelconque des revendications précédentes, où le film de liquide (15) présente une épaisseur de couche de 250 nm-10 mm.

6. Procédé selon l'une quelconque des revendications précédentes, où des ions qui sont à disposition comme produits de départ pour une réaction souhaitée en un produit se dissolvent dans le film de liquide (15), le produit se déposant, sous l'effet du rayonnement riche en énergie, en particulier un rayon laser (1), sur la pièce (3).

7. Procédé selon l'une quelconque des revendications précédentes, où le film de liquide (15) modifie son état d'agrégation, en particulier devient gazeux, sous l'effet du rayonnement.
